(19) **Europäisches Patentamt / European Patent Office / Office européen des brevets**

(11) **EP 4 435 450 B1**

(12) **EUROPEAN PATENT SPECIFICATION**

(45) Date of publication and mention
of the grant of the patent:
**11.03.2026  Bulletin 2026/11**

(51) International Patent Classification (IPC):
*G01R 31/36* (2020.01)    *G01R 31/3835* (2019.01)
*G01R 31/392* (2019.01)    *G01R 19/00* (2006.01)
*G01R 19/165* (2006.01)    *G01R 19/25* (2006.01)
*G01R 31/396* (2019.01)

(21) Application number: **22911643.9**

(22) Date of filing: **22.11.2022**

(52) Cooperative Patent Classification (CPC):
**G01R 31/392; G01R 19/2506; G01R 31/3835;
G01R 31/396;** G01R 19/16528; G01R 19/16542;
G01R 19/16566; Y02E 60/10

(86) International application number:
**PCT/KR2022/018489**

(87) International publication number:
**WO 2023/121006 (29.06.2023 Gazette 2023/26)**

(54) **BATTERY MANAGEMENT DEVICE AND METHOD FOR OPERATING SAME**

BATTERIEVERWALTUNGSVORRICHTUNG UND VERFAHREN ZUM BETRIEB DAVON

DISPOSITIF DE GESTION DE BATTERIE ET SON PROCÉDÉ DE FONCTIONNEMENT

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **23.12.2021  KR 20210186533**

(43) Date of publication of application:
**25.09.2024  Bulletin 2024/39**

(73) Proprietor: **LG Energy Solution, Ltd.
Seoul 07335 (KR)**

(72) Inventor: **KIM, Young Jin
Daejeon 34122 (KR)**

(74) Representative: **Plasseraud IP
104 Rue de Richelieu
CS92104
75080 Paris Cedex 02 (FR)**

(56) References cited:
WO-A1-2021/230642    GB-A- 2 532 726
KR-A- 20190 084 686    KR-A- 20210 068 789
KR-A- 20210 080 069    KR-A- 20210 080 069
KR-A- 20210 141 212    KR-B1- 101 697 907
US-B2- 8 796 986

## Description

[TECHNICAL FIELD]

<u>CROSS-REFERENCE TO RELATED APPLICATION</u>

This application claims priority to and the benefit of Korean Patent Application No. 10-2021-0186533 filed in the Korean Intellectual Property Office on December 23, 2021.

<u>TECHNICAL FIELD</u>

Embodiments disclosed herein relate to a battery management apparatus and an operating method thereof.

**[BACKGROUND ART]**

Recently, research and development of secondary batteries have been actively performed. Herein, the secondary batteries, which are chargeable/-dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium ion battery is attracting attention as a next-generation energy storage medium as a usage range thereof is expanded to a power source of electric vehicles. Furthermore, the secondary battery is generally used as a battery pack including a battery module where a plurality of battery cells are connected to one another in series and/or in parallel. Battery packs may be managed and controlled by a battery management apparatus in terms of their states and operations.

In such secondary batteries, an abnormal voltage drop phenomenon suspected to be an internal short-circuit is sometimes observed during a charge period. To detect this phenomenon, a differential signal regarding a voltage of a battery may be used.

KR20210080069 discloses an apparatus and a method for diagnosing a battery based on such a differential signal.

At this time, smoothing processing is performed to convert voltage data of the battery into the differential signal, and to obtain an optimal result, it is necessary to determine a smoothing parameter capable of achieving proper fitting with original data while low curve shaking of the differential signal.

**[DISCLOSURE]**

**[TECHNICAL PROBLEM]**

Embodiments disclosed herein aim to provide a battery management apparatus and an operating method thereof in which in a pre-processing process for converting voltage data of a battery into a differential signal, an optimal smoothing parameter is determined according to a set algorithm and the differential signal is obtained using the parameter.

Embodiments disclosed herein aim to provide a battery management apparatus and an operating method thereof in which an abnormal voltage drop phenomenon caused by an internal short-circuit during charge of a battery may be detected using a differential signal regarding a voltage of the battery and purposes such as quantification of battery deterioration, identification of abnormal deterioration, etc., may be further achieved.

Technical problems of the embodiments disclosed herein are not limited to the above-described technical problems, and other unmentioned technical problems would be clearly understood by one of ordinary skill in the art from the following description.

**[TECHNICAL SOLUTION]**

A battery management apparatus according to an embodiment includes a voltage measuring unit configured to measure a voltage of a battery cell and a controller configured to sample data regarding the voltage of the battery cell in a designated unit to convert the data into data in a monotonically increasing or monotonically decreasing form, smooth the data by using an optimal smoothing parameter determined according to a set algorithm, and convert the data regarding the voltage of the battery cell into a differential signal.

In the battery management apparatus, the controller is further configured to determine the optimal smoothing parameter by using an algorithm of minimizing a cost function.

In the battery management apparatus according to an embodiment, the controller is further configured to obtain a differential signal set corresponding to each smoothing parameter based on data smoothed using at least one preset smoothing parameters and calculate the cost function based on a curve length of each of the differential signal set and a difference between original data and each of the differential signal set.

In the battery management apparatus according to an embodiment, the controller may be further configured to calculate a cost function value corresponding to the smoothing parameter by multiplying a first variable that is a value obtained by linearly integrating a differential signal corresponding to the smoothing parameter in a designated section by a second variable that is a root mean square (RMS) value of a difference between the original data and the differential signal corresponding to the smoothing parameter.

In the battery management apparatus according to an embodiment, the controller may be further configured to determine a smoothing parameter that minimizes a corresponding cost function value among the at least one smoothing parameters.

In the battery management apparatus according to an embodiment, each of the at least one smoothing parameters may be a smoothing parameter in which a peak value of a corresponding differential signal does not exceed a designated value.

In the battery management apparatus according to an embodiment, the controller may be further configured to classify capacity values of the battery cell having the same voltage magnitude and calculate an average value of the capacity values of the battery cell for each voltage magnitude to perform sampling with respect to the voltage.

In the battery management apparatus according to an embodiment, the controller may be further configured to perform smoothing by using a smoothing algorithm to which a hyper parameter is applied such that a slope of the voltage of the battery cell satisfies continuity.

The battery management apparatus according to an embodiment may further include an abnormality diagnosing unit configured to calculate a statistical value for the differential signal and diagnose that abnormality of the battery cell occurs when the statistical value for the differential signal is equal to or greater than a preset reference value.

In the battery management apparatus according to an embodiment, the differential signal may be a voltage-capacity differential signal or a voltage-time differential signal of the battery cell.

An operating method of a battery management apparatus according to an embodiment includes measuring a voltage of a battery cell, sampling data regarding a voltage of a battery cell in a designated unit to convert the data into data in a monotonically increasing or monotonically decreasing form, smoothing the data by using an optimal smoothing parameter determined according to a set algorithm, and converting the data regarding the voltage of the battery cell into a differential signal.

In the operating method of the battery management apparatus, the smoothing of the data includes determining the optimal smoothing parameter by using an algorithm of minimizing a cost function.

In the operating method of the battery management apparatus according to an embodiment, the determining of the optimal smoothing parameter may include smoothing data regarding the voltage by using at least one preset smoothing parameters, obtaining a differential signal set corresponding to each smoothing parameter based on the smoothed data, and calculating the cost function based on a curve length of each of the differential signal set and a difference between original data and each of the differential signal set.

In the operating method of the battery management apparatus according to an embodiment, the calculating of the cost function may include calculating a cost function value corresponding to the smoothing parameter by multiplying a first variable that is a value obtained by linearly integrating a differential signal corresponding to the smoothing parameter in a designated section by a second variable that is a root mean square (RMS) value of a difference between the original data and the differential signal corresponding to the smoothing parameter.

In the operating method of the battery management apparatus according to an embodiment, the determining of the optimal smoothing parameter may further include determining a smoothing parameter that minimizes a corresponding cost function value among the at least one smoothing parameters.

In the operating method of the battery management apparatus according to an embodiment, each of the at least one smoothing parameters may be a smoothing parameter in which a peak value of a corresponding differential signal does not exceed a designated value.

In the operating method of the battery management apparatus according to an embodiment, the sampling of the data regarding the voltage in the designated unit to convert the data into data in the monotonically increasing or monotonically decreasing form may include classifying capacity values of the battery cell having the same voltage magnitude and calculating an average value of the capacity values of the battery cell for each voltage magnitude to perform sampling with respect to the voltage.

In the operating method of the battery management apparatus according to an embodiment, the smoothing of the data may include performing smoothing by using a smoothing algorithm to which a hyper parameter is applied such that a slope of the voltage of the battery cell satisfies continuity.

The operating method of the battery management apparatus according to an embodiment may further include calculating a statistical value for the differential signal and diagnosing that abnormality of the battery cell occurs when the statistical value for the differential signal is equal to or greater than a preset reference value.

In the operating method of the battery management apparatus according to an embodiment, the differential signal may be a voltage-capacity differential signal or a voltage-time differential signal of the battery cell.

## [ADVANTAGEOUS EFFECTS]

According to an embodiment, in a pre-processing process for converting data regarding a voltage of a battery into a differential signal, an optimal smoothing parameter may be determined, which enables proper fitting with original data while reducing fluctuation of a curve of a smoothed differential signal.

Moreover, it is possible to obtain a differential signal regarding a voltage of a battery (e.g., a voltage-capacity differential signal, a voltage-time differential signal, etc.) by using an optimal smoothing parameter, accurately and easily detect an abnormal voltage drop phenomenon caused by an internal short-circuit of the battery based on the differential signal, and achieve a purpose such as battery deterioration quantification, abnormal deterioration identification, or the like.

Moreover, various effects recognized directly or indirectly from the disclosure may be provided.

[DESCRIPTION OF DRAWINGS]

In order to more clearly describe technical solutions of embodiments disclosed herein or the prior art, the drawings required in the description of the embodiments are briefly introduced below. It should be understood that the following drawings are for the purpose of explaining the embodiments of the present specification and not for limiting purposes. In addition, representations of some components in the drawings may be exaggerated or omitted for clarity of explanation.

FIG. 1 is a block diagram showing a configuration of a battery control system.
FIG. 2 is a block diagram showing a configuration of a battery management apparatus according to an embodiment.
FIG. 3A is a graph showing raw data of a measured voltage of a battery, and FIG. 3B is a graph showing a differential signal of voltage raw data of FIG. 3A.
FIG. 4 is a diagram showing a method of performing sampling to remove a redundant signal of battery voltage data.
FIG. 5A is a graph showing a result of performing preprocessing on battery voltage data through sampling and smoothing, and FIG. 5B is a graph showing a differential abstract shape of battery voltage data for each pre-processing stage.
FIG. 6A is a graph showing a change of a signal form with respect to original data of a voltage-capacity differential signal and a smoothing parameter value, and FIG. 6B is a graph showing a change of a curve length L of a differential signal and a difference rms from original data with respect to a smoothing parameter value.
FIG. 7A is a graph showing a change in a cost function (L*rms) with respect to a smoothing parameter value for sampling at 1-second intervals, and FIG. 7B is a graph showing a change in a cost function (L*rms) with respect to a smoothing parameter value for sampling at 60-second intervals.
FIG. 8 is a flowchart showing an operating method of a battery management apparatus according to an embodiment.
FIG. 9 is a flowchart showing a detailed process of an operation of smoothing data in an operating method of a battery management apparatus according to an embodiment.
FIG. 10 is a flowchart showing an operating method of a battery management apparatus according to another embodiment.

[MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

Although terms used herein are selected with general terms popularly used at present under the consideration of functions in the disclosure, the terms may vary according to the intention of those of ordinary skill in the art, custom, or introduction of new technology. In addition, in a specific case, the applicant voluntarily may select terms, and in this case, the meaning of the terms may be disclosed in a corresponding description part of the present specification. Therefore, the terms used herein should be defined not by the simple names of the terms but by the substantial meaning of the terms and the contents throughout the disclosure.

Terms defined in the present disclosure are used for only describing a specific exemplary embodiment and may not have an intention to limit the scope of other exemplary embodiments. It is to be understood that the singular forms include plural references unless the context clearly dictates otherwise.

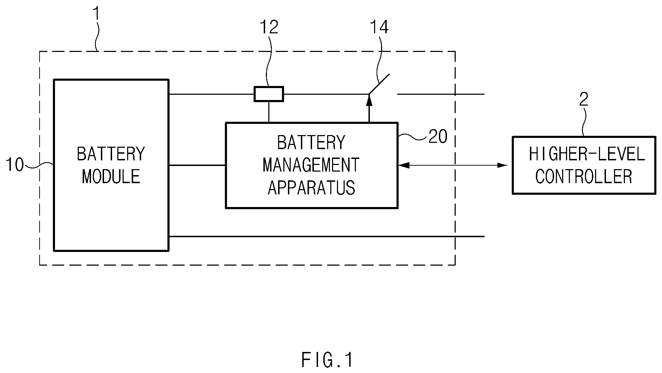

FIG. 1 is a block diagram showing a configuration of a battery control system according to an embodiment, schematically showing a battery control system including a battery pack 1 and a higher-level controller 2 included in a higher-level system. The battery pack 1 may be used for an energy storage system, a vehicle, etc., without being limited to such a purpose.

Referring to FIG. 1, the battery pack 1 may include a battery module 10 that includes one or more chargeable/dischargeable battery cells, a switching element 14 serially connected to a positive (+) terminal side or a negative (-) terminal side of the battery module 10 to control a charging/discharging current flow of the battery module 10, and a battery management apparatus 20 for control and management to prevent overcharge and over-discharge by monitoring voltage, current, temperature, etc., of the battery pack 1.

Herein, as the switching element 14 which is a semiconductor switching element for controlling a current flow for charge or discharge of the battery module 10, for example, at least one metal oxide semiconductor field effect transistor (MOSFET) may be used.

The battery management apparatus 20 may measure or calculate a voltage and a current of a gate, a source, a drain, etc., of the semiconductor switching element to monitor the voltage, the current, the temperature, etc., of the battery pack 1, and measure the current, the voltage, the temperature, etc., of the battery pack 1 by using a sensor 12 provided adjacent to the semiconductor switching element 14.

The battery management apparatus 20 may include a plurality of terminals as an interface for receiving measured values of various parameters described above, a circuit connected to the terminals to process received values, etc. The battery management apparatus 20 may control ON/OFF of the switching element 14, and may be connected to the battery module 10 to monitor a state of the battery module 10.

The higher-level controller 2 may transmit a control signal regarding the battery module to the battery management apparatus 20. Thus, the battery management apparatus 20 may be controlled in terms of an operation thereof based on a signal applied from the higher-level controller.

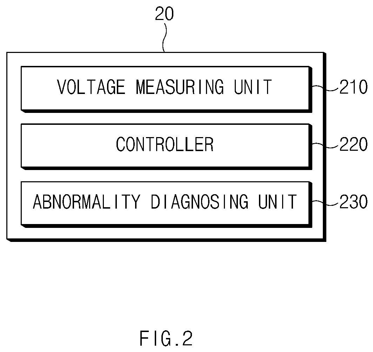

FIG. 2 is a block diagram showing a configuration of a battery management apparatus according to an embodiment.

Referring to FIG. 2, the battery management apparatus 20 according to an embodiment may include a voltage measuring unit 210 and a controller 220, and selectively, may further include an abnormality diagnosing unit 230.

The voltage measuring unit 210 may measure a voltage of a battery cell to obtain voltage data. For example, the voltage measuring unit 210 may be configured to measure voltages of one or more battery cells included in the battery module 10 at specific time intervals through the sensor 12 included in the battery pack 1 of FIG. 1.

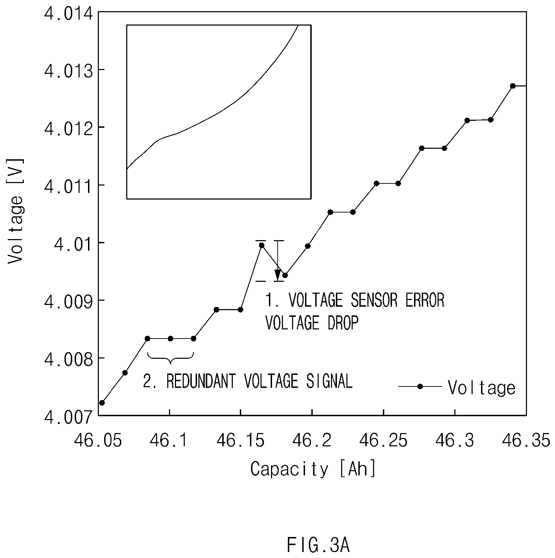

The controller 220 may pre-process voltage data (e.g., a voltage signal over time) of a battery cell to convert a voltage of the battery cell to be differentiable in a certain section. As illustrated in a graph of FIG. 3A, differential analysis of generally measured voltage data of the battery may be impossible due to a redundant signal, a discontinuous section, etc. Thus, the controller 220 may pre-process the voltage data of the battery cell before converting the differential signal to convert the voltage of the battery cell to be differentiable in a preset section.

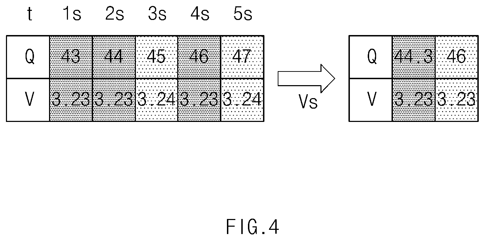

More specifically, the controller 220 may convert the voltage of the battery cell into data in the form of a monotonic increase (i.e., an increase without a decrease in a specific section) or a monotonic decrease (i.e., a decrease without an increase in a specific section). For example, the controller 220 may perform sampling with respect to a voltage by classifying capacity values Q of battery cells having an equal voltage magnitude V and calculating an average value of capacity values of battery cells for each voltage magnitude. This will be described later with reference to FIG. 4.

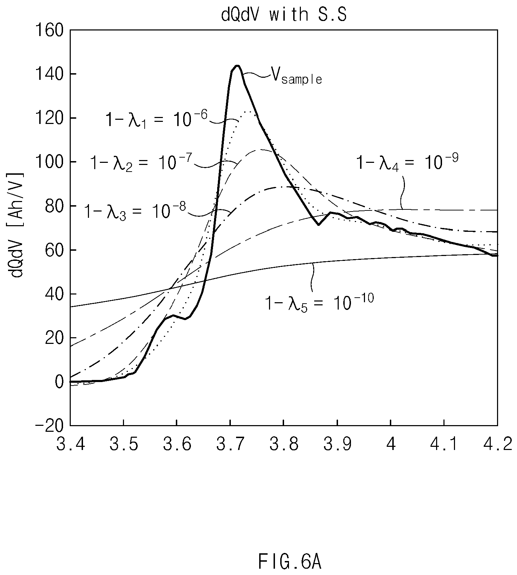

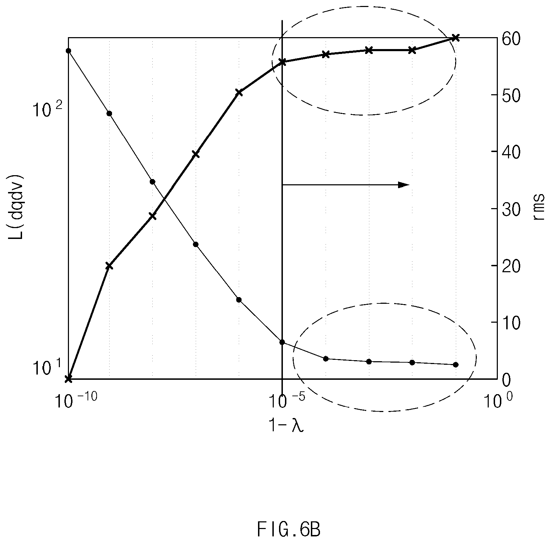

The controller 220 may convert a curve of a slope of voltage data of a battery cell into a smooth shape through smoothing of sampled data. In this way, continuity between adjacent data and voltage data may be differentiable in a specific section. According to a smoothing parameter value applied, the smoothness of the slope curve may vary with the smoothing parameter to be applied. For example, in case of a smoothing scheme according to an embodiment, the curve may become smooth as the parameter value increases, increasing a difference from original data, and it becomes closer to the original data as the parameter value decreases, increasing the fluctuation of the curve. Thus, when an optimal smoothing parameter is determined, variables in such a trade-off relationship need to be considered properly. This will be described later with reference to FIGS. 6A and 6B.

The controller 220 may convert voltage data of a battery cell, which has been pre-processed (sampled and smoothed) into a differential signal. In this case, the controller 220 may calculate a differential signal (e.g., dQ/dV, dV/dQ, dV/dt, etc.) regarding a capacity and a voltage of a battery cell. According to an embodiment, to determine an optimal parameter, the controller 220 may obtain a differential signal set corresponding to each of at least one preset smoothing parameters and determine an optimal smoothing parameter based on two or more variables (e.g., a smoothness of a differential signal curve, a difference from original data, etc.) for the differential signal set.

The abnormality diagnosing unit 230 may calculate a statistical value for the converted differential signal. **In** this case, the statistical value of the differential signal calculated by the controller 220 is intended to identify the abnormal behavior of the battery in a sliding window (or moving window) manner. For example, the statistical value of the differential signal may include a standard deviation.

The abnormality diagnosing unit 230 may diagnose abnormality of the battery cell based on the differential signal converted in the controller 220. More specifically, the abnormality diagnosing unit 230 may diagnose that an abnormal voltage drop occurs in the battery cell when the statistical value of the differential signal of a battery voltage is equal to or greater than a preset reference value.

The abnormality diagnosing unit 230 may diagnose abnormality of the battery cell in the sliding window manner for the statistical value of the differential signal of the battery voltage. As such, when the abnormality diagnosing unit 230 diagnoses abnormality of the battery cell in the sliding window manner, a size of a window may be set by a user at random. **In** this case, the statistical value of the differential signal of the battery voltage may include a standard deviation.

Although not shown, the battery management apparatus 20 according to an embodiment may further include a memory unit and an alarming unit. **In** this case, the memory unit may store a voltage of the battery cell,

measured by the voltage measuring unit 210, and a differential signal of the voltage, calculated by the controller 220. In addition, the alarming unit may generate a warning alarm when it is determined by the abnormality diagnosing unit 230 that abnormality occurs in the battery cell. In this case, the warning alarm may be provided in the form of a message on a display unit (not shown) connected to the battery control system, or light or a sound signal.

Although not shown, an additional device or system capable of executing a function such as battery deterioration quantification, abnormality deterioration identification, etc., may be included as well as the abnormality diagnosing unit 230.

Hereinbelow a pre-processing process for converting voltage data into a differentiable signal will be described in detail with reference to the drawings.

According to an embodiment, the controller 220 may sample data regarding a voltage of a battery cell in a designated unit to convert the data into data in a monotonically increasing or monotonically decreasing form.

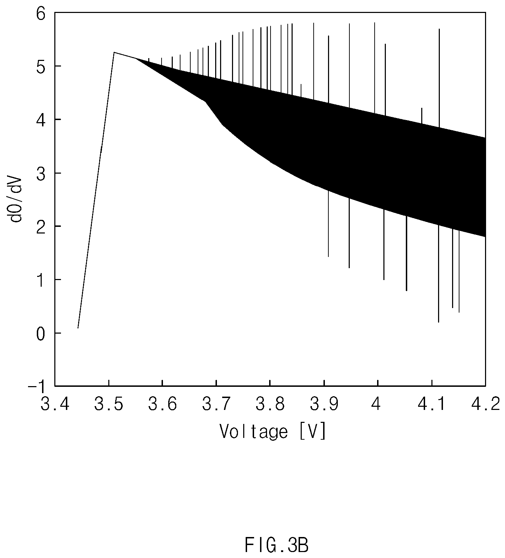

FIG. 3A is a graph showing raw data of a measured voltage of a battery, and FIG. 3B is a graph showing a differential signal of voltage raw data of FIG. 3A. In this case, a horizontal axis of FIG. 3A indicates a capacity Ah of a battery and a vertical axis indicates a measured voltage V of the battery. In addition, a horizontal axis of FIG. 3B indicates the voltage V of the battery and a vertical axis indicates a differential signal dQ/dV regarding a capacity and a voltage of the battery.

Referring to FIG. 3A, measured voltage data of the battery may include noise, a redundant voltage signal, etc., due to an error of a voltage sensor. Thus, as shown in FIG. 3B, it may be difficult to analyze a differential signal with respect to voltage or current data.

FIG. 4 is a diagram showing a method of performing sampling to remove a redundant signal of battery voltage data. Referring to FIG. 4, measured data of each of a capacity and a voltage of a battery with respect to time is shown. Herein, in sections where a capacity of the battery is 43 Ah, 44 Ah, and 46 Ah, a voltage is equal to 3.23 V, and in sections where the capacity of the battery is 45 Ah and 47 Ah, the voltage is equal to 3.24 V. Thus, as shown in FIGS. 3A and 3B, a redundant signal may occur in voltage data, making differential analysis impossible.

In such a case, for capacity and voltage data of the battery, capacity values of the battery may be classified based on a voltage of a particular magnitude, and an average value thereof may be calculated to sample battery voltage data. For example, as shown in FIG. 4, based on redundant battery voltages of 3.23 V and 3.24 V, an average value of capacity values corresponding to the respective voltages may be calculated. For example, for a voltage of 3.23 V, an average value of 44.3 Ah of battery capacities of 43 Ah, 44 Ah, and 46 Ah may be determined as a capacity value, and for a voltage of 3.24 V, an average value of 46 Ah of the battery capacities 45 Ah and 47 Ah may be determined as the capacity value.

As such, the controller 220 according to an embodiment may sample voltage data in a designated unit to convert voltage data into data in a monotonically increasing or monotonically decreasing form based on a measured voltage.

According to an embodiment, the controller 220 may perform smoothing such that the sampled data is differentiable in a preset section.

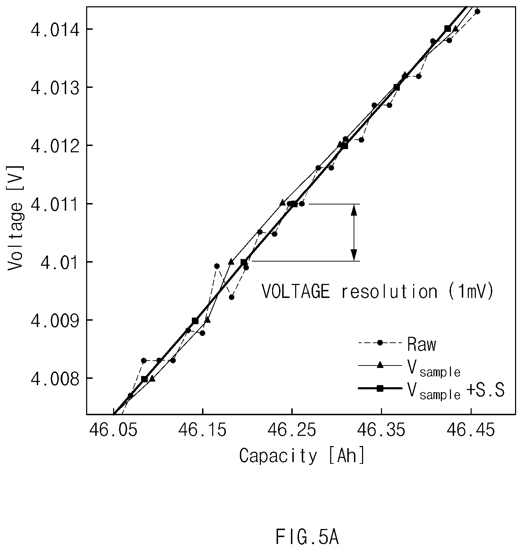

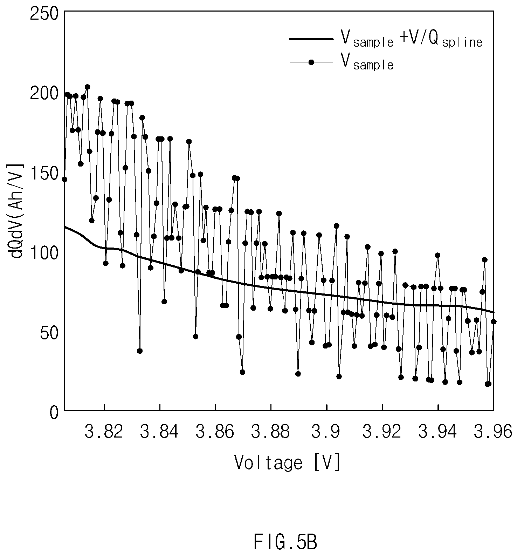

FIG. 5A is a graph showing a result of performing pre-processing on battery voltage data through sampling and smoothing, and FIG. 5B is a graph showing a differential abstract shape of battery voltage data for each pre-processing stage. In this case, a horizontal axis of FIG. 5A indicates a capacity Ah of a battery and a vertical axis indicates a measured voltage V of the battery. In addition, a horizontal axis of FIG. 5B indicates the voltage V of the battery and a vertical axis indicates a differential signal Ah/V regarding a capacity and a voltage of the battery.

As shown in FIG. 5A, a redundant signal and noise occur in raw data of a voltage, but voltage data sampled according to FIG. 4 appears in a monotonically increasing form.

Meanwhile, even when sampling is performed on raw data of a voltage, a section where differentiation is impossible may occur due to a slope difference between adjacent data. In this regard, referring to FIG. 5B, when sampling is simply performed on raw data of a voltage, a value of a differential signal may not be completely represented.

Thus, the controller 220 may smooth the sampled voltage data such that the slope of the voltage data of the battery satisfies continuity. According to an embodiment, a smoothing spline (S.S) scheme may be applied, and a calculation formula of the SS may be expressed as below.

$$\sum_{i=1}^{n}\{Y_i - f(x_i)\}^2 + \lambda \int f''(x)^2 dx$$

Through the S.S calculation formula, it is possible to prevent the slope of the sampled voltage data from rapidly changing and convert the same into a continuous curve. As a smoothing parameter $\lambda$ increases, the curve may become smoother. For example, $\lambda$ may be 0.001 V and 0.01 Q, respectively.

Meanwhile, a data pre-processing method according to embodiments disclosed herein may use any other data smoothing algorithms to which a hyper parameter (a variable input by a user in modeling) is applied, than the S.S scheme. An optimal smoothing parameter applied to each S.S scheme may be determined according to an embodiment described below.

Referring back to FIG. 5A, when S.S is applied to the sampled voltage data, the voltage data may be converted into a differentiable form while satisfying continuity of the slope of the voltage data. As shown in FIG.

5B, for a differential signal to which S.S is performed in addition to sampling, a graph appears smooth without noise.

As described above, the smoothness of the differential signal curve varies with the smoothing parameter $\lambda$, and the curve may become smooth as the parameter value increases, increasing a difference from original data, and it becomes closer to the original data as the parameter value decreases, increasing the fluctuation of the curve. Thus, disclosed embodiments provide an algorithm for determining an optimal smoothing parameter by using a cost function considering two elements in a tradeoff relationship.

According to an embodiment, the controller 220 may smooth data by applying at least one preset parameters (e.g., $\lambda_1, \lambda_2, ..., \lambda_5$), and obtain a differential signal set corresponding to each smoothing parameter. Herein, each of the at least one smoothing parameters may be a smoothing parameter in which a peak value of a corresponding differential signal does not exceed a designated value.

FIG. 6A is a graph showing a change of a signal form with respect to original data $V_{sample}$ of a voltage-capacity differential signal dQ/dV and the smoothing parameters $\lambda_1, \lambda_2, ..., \lambda_5$, according to an embodiment. Referring to FIG. 6A, it may be seen that as the smoothing parameter $\lambda$ increases (i.e., as $(1 - \lambda)$ decreases to $10^{-6}$, $10^{-7}, ..., 10^{-10}$), the curve becomes smooth, but a difference from the original data increases.

The cost function may be calculated for each differential signal set, simultaneously considering the smoothness of the curve and a difference from the original data. According to an embodiment, the smoothness of the curve may be represented as a first variable that is a value obtained by linearly integrating the differential signal in a certain section (e.g., a section where a voltage magnitude is 3.4 V to 4.2 V), and a difference from the original data may be represented as a second variable that is a root mean square (RMS) value of a difference between the original data and the differential signal. That is, as the smoothing parameter value increases ($1 - \lambda$ decreases), the curve of the differential signal becomes smooth and the first variable indicating the length of the curve decreases. On the other hand, as the smoothing parameter value increases ($1 - \lambda$ decreases), the second variable indicating the difference from the original data increases.

FIG. 6B is a graph showing a change of a curve length L of a differential signal and a difference rms from original data with respect to a smoothing parameter value $\lambda$. Referring to FIG. 6B, it may be seen that as the smoothing parameter $\lambda$ increases (i.e., as $(1 - \lambda)$ decreases to $10^{-6}, 10^{-7}, ..., 10^{-10}$), the length L of the curve decreases and the difference rms from the original data increases.

According to an embodiment, the controller 220 may calculate a cost function value corresponding to each smoothing parameter by multiplying the first variable (the curve length of the differential signal) by the second variable (the difference rms from the original data). Among the smoothing parameters (e.g., $\lambda_1$, $\lambda_2, ..., \lambda_5$), a smoothing parameter that minimizes a corresponding cost function value may be determined as an optimal smoothing parameter. The optimal smoothing parameter determined considering the cost function may mean a parameter value that enables proper fitting with the original data while reducing the fluctuation of the generated data (e.g., the differential signal such as dQ/dV, dV/dQ, dV/dt, etc.) curve.

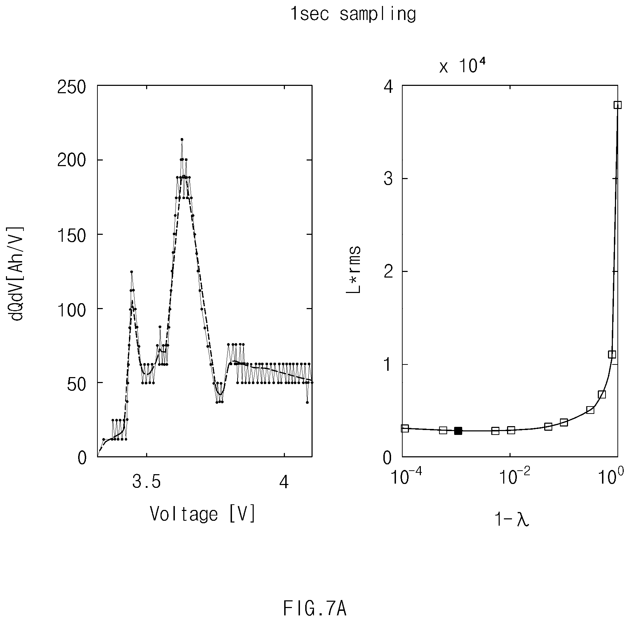

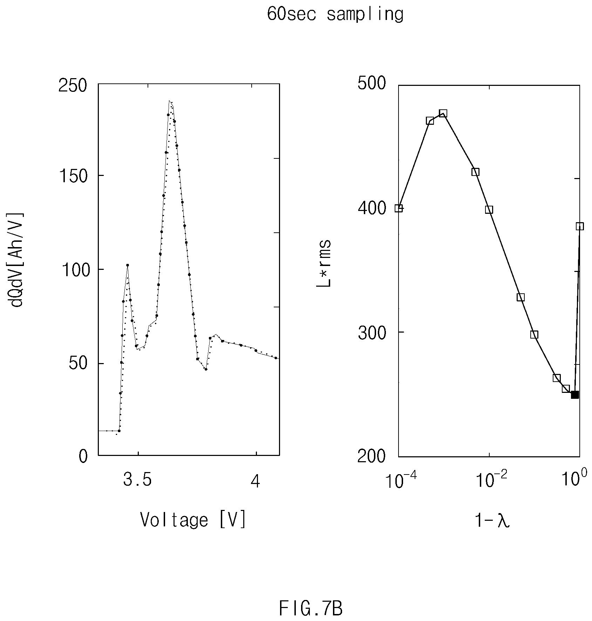

FIG. 7A is a graph showing a change in a cost function (L*rms) with respect to a smoothing parameter value for sampling at 1-second intervals, and FIG. 7B is a graph showing a change in a cost function (L*rms) with respect to a smoothing parameter value for sampling at 60-second intervals. It may be seen that a smoothing parameter value that minimizes a cost function varies with sampling variation. That is, different smoothing parameters are applied depending on a measurement environment, and an optimal smoothing parameter may be determined by applying consistent standards rather than empirical implementation.

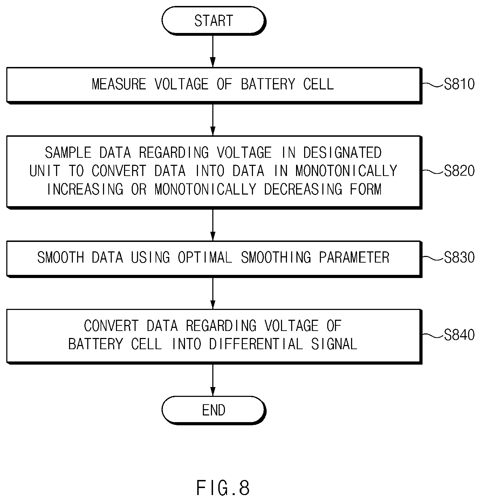

FIG. 8 is a flowchart showing an operating method of a battery management apparatus according to an embodiment. A structure and components of the battery management structure are as described above with reference to FIG. 1.

Referring to FIG. 8, in the operating method of the battery management apparatus according to an embodiment, first, operation S810 of measuring a voltage of a battery cell is performed. For example, the voltage measuring unit 210 of the battery management apparatus 20 may obtain voltage data by measuring the voltage of the battery cell through the provided sensor 12 (see FIGS. 1 and 2).

Next, operation S820 of sampling voltage data in a designated unit for conversion into data in a monotonically increasing or monotonically decreasing form is performed. The controller 220 of the battery management apparatus 20 may sample the voltage data of the battery cell measured by the voltage measuring unit 210 for conversion into data in a form of increasing without decreasing (monotonically increasing) in a certain section or decreasing without increasing (monotonically decreasing) in a certain section (see FIG. 5A).

According to a detailed embodiment, operation S820 may include an operation of classifying capacity values of the battery cell having the same voltage magnitude and calculating an average value of the capacity values of the battery cell for each voltage magnitude to perform sampling with respect to the voltage (see FIG. 4).

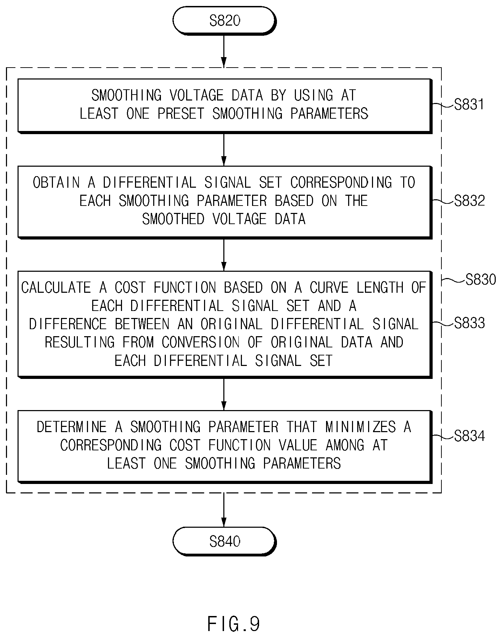

Next, operation S830 of smoothing data by using an optimal smoothing parameter may be performed. The controller 220 may be configured to satisfy continuity between adjacent data through a smoothing process of converting a curve of a slope of the sampled data into a smooth form. A detailed process of operation 830 will be described later with reference to FIG. 9.

Next, operation S840 of converting the data regarding the voltage of the battery cell into a differential signal may be performed. The controller 220 may convert the voltage data of the battery cell on which pre-processing operations S820 and S830 have been completed into a differential signal (e.g., the voltage-capacity differential signal dQ/dV). The voltage-capacity differential signal may be used to detect the abnormal voltage drop phenomenon of the battery cell.

FIG. 9 is a flowchart showing a detailed process of an operation of determining an optimal smoothing parameter using a set algorithm and smoothing data using the same, in an operating method of a battery management apparatus according to an embodiment.

Referring to FIG. 9, operation S831 of smoothing voltage data by using at least one preset smoothing parameters may be performed. According to an embodiment, each of the at least one smoothing parameters may be a smoothing parameter in which a peak value of a corresponding differential signal does not exceed a designated value.

Then, operation S832 of obtaining a differential signal set corresponding to each smoothing parameter based on the smoothed voltage data may be performed. In this case, the smoothness of each differential signal curve varies with the smoothing parameter, and the curve may become smooth as the parameter value increases, increasing a difference from original data, and it becomes closer to the original data as the parameter value decreases, increasing the fluctuation of the curve.

Next, operation S833 of calculating a cost function based on a curve length of each differential signal set and a difference between an original differential signal resulting from conversion of original data and each differential signal set may be performed. The controller 220 may calculate a cost function by simultaneously considering the smoothness of the differential signal curve and the difference from the original data.

According to an embodiment, operation S833 of calculating the cost function may include an operation of calculating a cost function value corresponding to the smoothing parameter by multiplying a first variable that is a value obtained by linearly integrating the differential signal corresponding to the smoothing parameter in a designated section by a second variable that is an RMS value of a difference between the original data and the differential signal corresponding to the smoothing parameter.

Thereafter, operation S834 of determining a smoothing parameter that minimizes a corresponding cost function value among at least one smoothing parameters may be performed. As such, the optimal smoothing parameter determined considering the cost function may mean a parameter value that enables proper fitting with the original data while reducing the fluctuation of the generated data (e.g., dQ/dV data) curve.

In this way, by using a random smoothing algorithm (e.g., a smoothing spline) to which a hyper parameter is applied, the slope of the voltage of the battery cell may satisfy continuity.

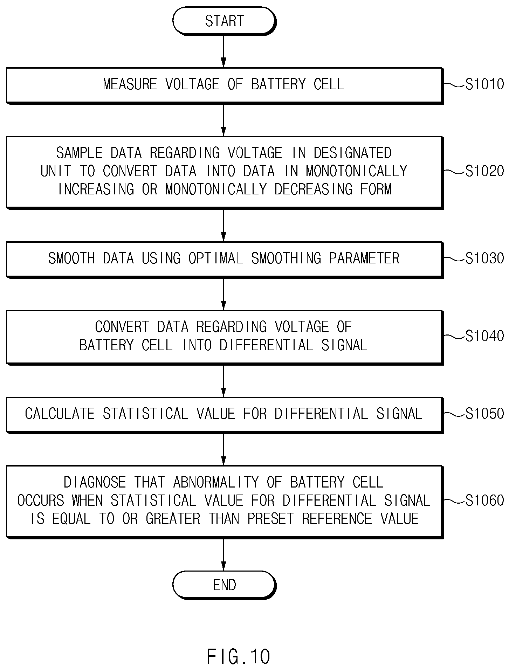

FIG. 10 is a flowchart showing an operating method of a battery management apparatus according to another embodiment. Operations S1010 to S1040 of FIG. 10 may be substantially the same as operations S810 to S840 of FIG. 8, and thus a redundant description thereof will be omitted.

Following operation S1040 of converting the voltage of the battery cell into the differential signal, operation S1050 of calculating a statistical value for the differential signal may be performed. In this case, the statistical value of the differential signal may be intended to identify the abnormal behavior of the battery in a sliding window (or moving window) manner. For example, the statistical value of the differential signal may include a standard deviation.

Next, operation S1060 of diagnosing that abnormality of the battery cell occurs when the statistical value for the differential signal is equal to or greater than a preset reference value may be performed. More specifically, the abnormality diagnosing unit 230 may diagnose that an abnormal voltage drop occurs in the battery cell when the statistical value of the differential signal of a battery voltage is equal to or greater than a preset reference value.

Although not shown, an operation of storing the measured voltage of the battery cell, the differential signal, etc., in the memory unit and/or an operation of generating a warning alarm when determining that abnormality occurs in the battery cell may be further provided. In this case, the warning alarm may be provided in the form of a message on a display unit (not shown), or light or a sound signal.

The operating method of the battery management apparatus according to the embodiment may be embodiment implemented in the form of an application or a program instruction that is executable through various computer components and recorded in a computer-readable recording medium. The computer-readable recording medium may include a program instruction, a data file, a data structure and the like solely or in a combined manner.

According to an embodiment described above, in a pre-processing process for converting data regarding a voltage of a battery into a differential signal, an optimal smoothing parameter determined according to a set algorithm, i.e., the smoothing parameter may be determined, which enables proper fitting with original data while reducing fluctuation of a curve of a smoothed differential signal. Moreover, it is possible to obtain a differential signal regarding a voltage of a battery (e.g., a voltage-capacity differential signal) by using an optimal smoothing parameter, accurately and easily detect an abnormal voltage drop phenomenon caused by an internal short-circuit of the battery based on the differential signal, and achieve a purpose such as battery deterioration quantification, abnormal deterioration identification, or the like.

So far, all components constituting the embodiment have been described as being combined or operating in combination, but it is not necessarily limited to this embodiment, and within the scope of the purpose, all components may be selectively combined with one or more to operate. Moreover, terms such as "include", "constitute", "have", etc., described above may mean that the corresponding component may be inherent unless otherwise stated, and thus should be construed as further including other components rather than excluding other components.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the content of the embodiments disclosed herein and the scope of the content of the present disclosure is not limited by these embodiments disclosed herein. The protection scope of the content disclosed herein is defined by the following claims.

## Claims

1. A battery management apparatus (20) comprising:

   a voltage measuring unit (210) configured to measure a voltage of a battery cell; and
   a controller (220) configured to sample data regarding the voltage of the battery cell in a designated unit to convert the data into data in a monotonically increasing or monotonically decreasing form, smooth the data by using an optimal smoothing parameter determined according to a set algorithm, and convert the data regarding the voltage of the battery cell into a differential signal,
   and wherein the controller (220) is further configured to determine the optimal smoothing parameter by using as the set algorithm an algorithm of minimizing a cost function.

2. The battery management apparatus (20) of claim 1, wherein the controller (220) is further configured to:

   obtain a differential signal set corresponding to each smoothing parameter based on data smoothed using at least one preset smoothing parameters; and
   calculate the cost function based on a curve length of each of the differential signal set and a difference between original data and each of the differential signal set.

3. The battery management apparatus (20) of claim 2, wherein the controller (220) is further configured to calculate a cost function value corresponding to the smoothing parameter by multiplying a first variable that is a value obtained by linearly integrating a differential signal corresponding to the smoothing parameter in a designated section by a second variable that is a root mean square (RMS) value of a difference between the original data and the differential signal corresponding to the smoothing parameter.

4. The battery management apparatus (20) of claim 3, wherein the controller (220) is further configured to determine a smoothing parameter that minimizes a corresponding cost function value among the at least one smoothing parameters.

5. The battery management apparatus (20) of claim 4, wherein each of the at least one smoothing parameters is a smoothing parameter in which a peak value of a corresponding differential signal does not exceed a designated value.

6. The battery management apparatus (20) of claim 1, wherein the controller (220) is further configured to classify capacity values of the battery cells having the same voltage magnitude and calculate an average value of the capacity values of the battery cell for each voltage magnitude to perform sampling with respect to the voltage.

7. The battery management apparatus (20) of claim 1, wherein the controller (220) is further configured to perform smoothing by using a smoothing algorithm to which a hyper parameter is applied such that a slope of the voltage of the battery cell satisfies continuity.

8. The battery management apparatus (20) of claim 1, further comprising an abnormality diagnosing unit (230) configured to calculate a statistical value for the differential signal and diagnose that abnormality of the battery cell occurs when the statistical value for the differential signal is equal to or greater than a preset reference value.

9. The battery management apparatus (20) of claim 1, wherein the differential signal is a voltage-capacity differential signal or a voltage-time differential signal of the battery cell.

10. An operating method of a battery management apparatus, the operating method comprising:

Measuring (S810) a voltage of a battery cell;
Sampling (S820) data regarding a voltage of a battery cell in a designated unit to convert the data into data in a monotonically increasing or monotonically decreasing form;
smoothing (S830) the data by using an optimal smoothing parameter determined according to a set algorithm; and
converting (S840) the data regarding the voltage of the battery cell into a differential signal,

and wherein the smoothing (S830) of the data comprises determining the optimal smoothing parameter by using an algorithm of minimizing a cost function.

11. The operating method of claim 10, wherein the determining of the optimal smoothing parameter comprises:

smoothing (S831) data regarding the voltage by using at least one preset smoothing parameters;
obtaining (S832) a differential signal set corresponding to each smoothing parameter based on the smoothed data; and
calculating (S833) the cost function based on a curve length of each of the differential signal set and a difference between original data and each of the differential signal set.

12. The operating method of claim 11, wherein the calculating (S833) of the cost function comprises calculating a cost function value corresponding to the smoothing parameter by multiplying a first variable that is a value obtained by linearly integrating a differential signal corresponding to the smoothing parameter in a designated section by a second variable that is a root mean square (RMS) value of a difference between the original data and the differential signal corresponding to the smoothing parameter.

13. The operating method of claim 12, wherein the determining of the optimal smoothing parameter further comprises determining (S834) a smoothing parameter that minimizes a corresponding cost function value among the at least one smoothing parameters.

**Patentansprüche**

1. Batterie-Verwaltungsvorrichtung (20), umfassend:

eine Spannung-Messeinheit (210), welche dazu eingerichtet ist, eine Spannung einer Batteriezelle zu messen; und
eine Steuereinheit (220), welche dazu eingerichtet ist, Daten hinsichtlich der Spannung der Batteriezelle in einer designierten Einheit aufzunehmen, um die Daten in eine monoton zunehmende oder monoton abnehmende Form zu konvertieren, die Daten durch Verwendung eines optimalen Glättungsparameters zu glätten, welcher gemäß einem festgelegten Algorithmus bestimmt wird, und die Daten hinsichtlich der Spannung der Batteriezelle in ein differentielles Signal zu konvertieren,
und wobei die Steuereinheit (220) ferner dazu eingerichtet ist, den optimalen Glättungsparameter durch Verwendung eines Algorithmus eines Minimierens einer Kostenfunktion als den festgelegten Algorithmus zu bestimmen.

2. Batterie-Verwaltungsvorrichtung (20) nach Anspruch 1, wobei die Steuereinheit (220) ferner dazu eingerichtet ist:

einen differentiellen Signalsatz gemäß jedem Glättungsparameter auf Grundlage von Daten zu erhalten, welche unter Verwendung von wenigstens einem zuvor festgelegten Glättungsparameter geglättet werden; und
die Kostenfunktion auf Grundlage einer Kurvenlänge von jedem aus dem differentiellen Signalsatz und einer Differenz zwischen ursprünglichen Daten und jedem aus dem differentiellen Signalsatz zu berechnen.

3. Batterie-Verwaltungsvorrichtung (20) nach Anspruch 2, wobei die Steuereinheit (220) ferner dazu eingerichtet ist, einen Kostenfunktion-Wert zu berechnen, welcher dem Glättungsparameter entspricht, durch Multiplizieren einer ersten Variablen, welche ein Wert ist, welcher durch lineares Integrieren eines differentiellen Signals entsprechend dem Glättungsparameter in einem designierten Abschnitt erhalten wird, mit einer zweiten Variablen, welche ein quadratischer Mittelwert (RMS) einer Differenz zwischen den ursprünglichen Daten und dem differentiellen Signal entsprechend dem Glättungsparameter ist.

4. Batterie-Verwaltungsvorrichtung (20) nach Anspruch 3, wobei die Steuereinheit (220) ferner dazu eingerichtet ist, einen Glättungsparameter zu bestimmen, welcher einen entsprechenden Kostenfunktion-Wert minimiert, unter dem wenigstens einen Glättungsparameter.

5. Batterie-Verwaltungsvorrichtung (20) nach Anspruch 4, wobei jeder aus dem wenigstens einen Glättungsparameter ein Glättungsparameter ist, in welchem ein Spitzenwert eines entsprechenden differentiellen Signals einen designierten Wert nicht übersteigt.

6. Batterie-Verwaltungsvorrichtung (20) nach Anspruch 1, wobei die Steuereinheit (220) ferner dazu eingerichtet ist, Kapazitätswerte der Batteriezellen zu klassifizieren, welche dieselbe Spannungsgröße aufweisen, und einen Durchschnittswert der Kapazitätswerte der Batteriezelle für jede Spannungsgröße zu berechnen, um eine Aufnahme bezüglich der Spannung durchzuführen.

7. Batterie-Verwaltungsvorrichtung (20) nach Anspruch 1, wobei die Steuereinheit (220) ferner dazu eingerichtet ist, ein Glätten durch Verwendung eines Glättungsalgorithmus durchzuführen, auf welchen ein Hyperparameter angewendet wird, so dass eine Steigung der Spannung der Batteriezelle eine Kontinuität erfüllt.

8. Batterie-Verwaltungsvorrichtung (20) nach Anspruch 1, ferner umfassend eine Anomalie-Diagnoseeinheit (230), welche dazu eingerichtet ist, einen statistischen Wert für das differentielle Signal zu berechnen und zu diagnostizieren, dass eine Anomalie der Batteriezelle auftritt, wenn der statistische Wert für das differentielle Signal gleich oder größer als ein zuvor festgelegter Referenzwert ist.

9. Batterie-Verwaltungsvorrichtung (20) nach Anspruch 1, wobei das differentielle Signal ein differentielles Spannung-Kapazität-Signal oder ein differentielles Spannung-Zeit-Signal der Batteriezelle ist.

10. Betriebsverfahren einer Batterie-Verwaltungsvorrichtung, wobei das Betriebsverfahren umfasst:

Messen (S810) einer Spannung einer Batteriezelle;
Aufnehmen (S820) von Daten hinsichtlich einer Spannung einer Batteriezelle in einer designierten Einheit, um die Daten in Daten in einer monoton steigenden oder monoton fallenden Form zu konvertieren;
Glätten (S830) der Daten durch Verwenden eines optimalen Glättungsparameters, welcher gemäß einem festgelegten Algorithmus bestimmt wird; und
Konvertieren (S840) der Daten hinsichtlich der Spannung der Batteriezelle in ein differentielles Signal,
und wobei das Glätten (S830) der Daten ein Bestimmen des optimalen Glättungsparameters durch Verwenden eines Algorithmus eines Minimierens einer Kostenfunktion umfasst.

11. Betriebsverfahren nach Anspruch 10, wobei das Bestimmen des optimalen Glättungsparameters umfasst:

Glätten (S831) von Daten hinsichtlich der Spannung durch Verwenden von wenigstens einem zuvor festgelegten Glättungsparameter;
Erhalten (S832) eines differentiellen Signalsatzes entsprechend jedem Glättungsparameter auf Grundlage der geglätteten Daten; und
Berechnen (S833) der Kostenfunktion auf Grundlage einer Kurvenlänge von jedem aus dem differentiellen Signalsatz und einer Differenz zwischen ursprünglichen Daten und jedem aus dem differentiellen Signalsatz.

12. Betriebsverfahren nach Anspruch 11, wobei das Berechnen (S833) der Kostenfunktion ein Berechnen eines Kostenfunktion-Werts entsprechend dem Glättungsparameter umfasst, durch Multiplizieren einer ersten Variablen, welche ein Wert ist, welcher durch lineares Integrieren eines differentiellen Signals entsprechend dem Glättungsparameter in einem designierten Abschnitt erhalten wird, mit einer zweiten Variablen, welche ein quadratischer Mittelwert (RMS) einer Differenz zwischen den ursprünglichen Daten und dem differentiellen Signal entsprechend dem Glättungsparameter ist.

13. Betriebsverfahren nach Anspruch 12, wobei das Bestimmen des optimalen Glättungsparameters ferner ein Bestimmen (S834) eines Glättungsparameters umfasst, welcher einen entsprechenden Kostenfunktion-Wert minimiert, unter dem wenigstens einen Glättungsparameter.

## Revendications

1. Dispositif de gestion de batterie (20) comprenant :

une unité de mesure de tension (210) configurée pour mesurer une tension d'une cellule de batterie ; et
un dispositif de commande (220) configuré pour échantillonner des données concernant la tension de la cellule de batterie dans une unité désignée pour convertir les données en données sous forme croissante monotone ou décroissante monotone, lisser les données en utilisant un paramètre de lissage optimal déterminé selon un algorithme défini, et convertir les données concernant la tension de la cellule de batterie en un signal différentiel,
et dans lequel le dispositif de commande (220) est en outre configuré pour déterminer le paramètre de lissage optimal en utilisant comme algorithme défini un algorithme de minimisation d'une fonction de coût.

2. Dispositif de gestion de batterie (20) selon la revendication 1, dans lequel le dispositif de commande (220) est en outre configuré pour :

obtenir un ensemble de signaux différentiels correspondant à chaque paramètre de lissage sur la base de données lissées en utilisant au moins un paramètre de lissage prédéfini ; et calculer la fonction de coût sur la base d'une longueur de courbe de chacun de l'ensemble de signaux différentiels et d'une différence entre les données d'origine et chacun de l'ensemble de signaux différentiels.

3. Dispositif de gestion de batterie (20) selon la revendication 2, dans lequel le dispositif de commande (220) est en outre configuré pour calculer une valeur de fonction de coût correspondant au paramètre de lissage en multipliant une première variable qui est une valeur obtenue par intégration linéaire d'un signal différentiel correspondant au paramètre de lissage dans une section désignée par une seconde variable qui est une valeur moyenne quadratique (RMS) d'une différence entre les données d'origine et le signal différentiel correspondant au paramètre de lissage.

4. Dispositif de gestion de batterie (20) selon la revendication 3, dans lequel le dispositif de commande (220) est en outre configuré pour déterminer un paramètre de lissage qui minimise une valeur de fonction de coût correspondante parmi les au moins un paramètre de lissage.

5. Dispositif de gestion de batterie (20) selon la revendication 4, dans lequel chacun des au moins un paramètre de lissage est un paramètre de lissage dans lequel une valeur de crête d'un signal différentiel correspondant ne dépasse pas une valeur désignée.

6. Dispositif de gestion de batterie (20) selon la revendication 1, dans lequel le dispositif de commande (220) est en outre configuré pour classifier des valeurs de capacité des cellules de batterie ayant la même magnitude de tension et calculer une valeur moyenne des valeurs de capacité de la cellule de batterie pour chaque magnitude de tension pour réaliser un échantillonnage par rapport à la tension.

7. Dispositif de gestion de batterie (20) selon la revendication 1, dans lequel le dispositif de commande (220) est en outre configuré pour réaliser un lissage en utilisant un algorithme de lissage auquel un hyperparamètre est appliqué de sorte qu'une pente de la tension de la cellule de batterie soit continue.

8. Dispositif de gestion de batterie (20) selon la revendication 1, comprenant en outre une unité de diagnostic d'anomalie (230) configurée pour calculer une valeur statistique pour le signal différentiel et diagnostiquer que l'anomalie de la cellule de batterie se produit lorsque la valeur statistique pour le signal différentiel est égale ou supérieure à une valeur de référence prédéfinie.

9. Dispositif de gestion de batterie (20) selon la revendication 1, dans lequel le signal différentiel est un signal différentiel de tension-capacité ou un signal différentiel de tension-temps de la cellule de batterie.

10. Procédé de fonctionnement d'un dispositif de gestion de batterie, le procédé de fonctionnement comprenant :

la mesure (S810) d'une tension d'une cellule de batterie ;
l'échantillonnage (S820) de données concernant une tension d'une cellule de batterie dans une unité désignée pour convertir les données en données sous une forme croissante monotone ou décroissante monotone ;
le lissage (S830) des données en utilisant un paramètre de lissage optimal déterminé selon un algorithme défini ; et
la conversion (S840) des données concernant la tension de la cellule de batterie en un signal différentiel,
et dans lequel le lissage (S830) des données comprend la détermination du paramètre de lissage optimal en utilisant un algorithme de minimisation d'une fonction de coût.

11. Procédé de fonctionnement selon la revendication 10, dans lequel la détermination du paramètre de lissage optimal comprend :

le lissage (S831) de données concernant la tension en utilisant au moins un paramètre de lissage prédéfini ;
l'obtention (S832) d'un ensemble de signaux différentiels correspondant à chaque paramètre de lissage sur la base des données lissées ; et
le calcul (S833) de la fonction de coût sur la base d'une longueur de courbe de chacun de l'ensemble de signaux différentiels et d'une différence entre les données d'origine et chacun de l'ensemble de signaux différentiels.

12. Procédé de fonctionnement selon la revendication 11, dans lequel le calcul (S833) de la fonction de coût comprend le calcul d'une valeur de fonction de coût correspondant au paramètre de lissage en multipliant une première variable qui est une valeur obtenue par intégration linéaire d'un signal différentiel correspondant au paramètre de lissage dans une section désignée par une seconde variable qui est une valeur de moyenne quadratique (RMS) d'une différence entre les données d'origine et le signal différentiel correspondant au paramètre de lissage.

**13.** Procédé de fonctionnement selon la revendication 12, dans lequel la détermination du paramètre de lissage optimal comprend en outre la détermination (S834) d'un paramètre de lissage qui minimise une valeur de fonction de coût correspondante parmi les au moins un paramètre de lissage.

FIG.1

20

VOLTAGE MEASURING UNIT ~210

CONTROLLER ~220

ABNORMALITY DIAGNOSING UNIT ~230

FIG.2

FIG.3A

FIG.3B

| t | 1s | 2s | 3s | 4s | 5s |
|---|----|----|----|----|----|
| Q | 43 | 44 | 45 | 46 | 47 |
| V | 3.23 | 3.23 | 3.24 | 3.23 | 3.24 |

Vs

| Q | 44.3 | 46 |
|---|------|----|
| V | 3.23 | 3.23 |

FIG.4

FIG.5A

FIG.5B

FIG.6A

FIG.6B

1sec sampling

FIG.7A

60sec sampling

FIG.7B

START

MEASURE VOLTAGE OF BATTERY CELL ~S810

SAMPLE DATA REGARDING VOLTAGE IN DESIGNATED
UNIT TO CONVERT DATA INTO DATA IN MONOTONICALLY
INCREASING OR MONOTONICALLY DECREASING FORM ~S820

SMOOTH DATA USING OPTIMAL SMOOTHING PARAMETER ~S830

CONVERT DATA REGARDING VOLTAGE OF
BATTERY CELL INTO DIFFERENTIAL SIGNAL ~S840

END

FIG.8

```
┌─────────────┐
│    S820     │
└─────────────┘
       │
       ▼
┌ ─ ─ ─ ─ ─ ─ ─ ─ ─ ─ ─ ─ ─ ─ ─ ─ ─ ─ ─ ─ ─ ┐
│  ┌──────────────────────────────────────┐   │
│  │   SMOOTHING VOLTAGE DATA BY USING AT  │──┼─ S831
│  │  LEAST ONE PRESET SMOOTHING PARAMETERS│   │
│  └──────────────────────────────────────┘   │
│                    │                         │
│                    ▼                         │
│  ┌──────────────────────────────────────┐   │
│  │ OBTAIN A DIFFERENTIAL SIGNAL SET      │   │
│  │ CORRESPONDING TO EACH SMOOTHING       │──┼─ S832
│  │ PARAMETER BASED ON THE SMOOTHED       │   │
│  │ VOLTAGE DATA                          │   │
│  └──────────────────────────────────────┘   │
│                    │                         │── S830
│                    ▼                         │
│  ┌──────────────────────────────────────┐   │
│  │ CALCULATE A COST FUNCTION BASED ON A  │   │
│  │ CURVE LENGTH OF EACH DIFFERENTIAL     │   │
│  │ SIGNAL SET AND A DIFFERENCE BETWEEN   │──┼─ S833
│  │ AN ORIGINAL DIFFERENTIAL SIGNAL       │   │
│  │ RESULTING FROM CONVERSION OF ORIGINAL │   │
│  │ DATA AND EACH DIFFERENTIAL SIGNAL SET │   │
│  └──────────────────────────────────────┘   │
│                    │                         │
│                    ▼                         │
│  ┌──────────────────────────────────────┐   │
│  │ DETERMINE A SMOOTHING PARAMETER THAT  │   │
│  │ MINIMIZES A CORRESPONDING COST        │──┼─ S834
│  │ FUNCTION VALUE AMONG AT LEAST ONE     │   │
│  │ SMOOTHING PARAMETERS                  │   │
│  └──────────────────────────────────────┘   │
└ ─ ─ ─ ─ ─ ─ ─ ─ ─ ─ ─ ─ ─ ─ ─ ─ ─ ─ ─ ─ ─ ┘
       │
       ▼
┌─────────────┐
│    S840     │
└─────────────┘
```

FIG.9

```
                    ┌──────────────┐
                    │    START     │
                    └──────┬───────┘
                           │
    ┌──────────────────────▼──────────────────────┐
    │      MEASURE VOLTAGE OF BATTERY CELL         │──S1010
    └──────────────────────┬──────────────────────┘
                           │
    ┌──────────────────────▼──────────────────────┐
    │   SAMPLE DATA REGARDING VOLTAGE IN DESIGNATED│
    │ UNIT TO CONVERT DATA INTO DATA IN MONOTONICALLY│──S1020
    │   INCREASING OR MONOTONICALLY DECREASING FORM │
    └──────────────────────┬──────────────────────┘
                           │
    ┌──────────────────────▼──────────────────────┐
    │  SMOOTH DATA USING OPTIMAL SMOOTHING PARAMETER│──S1030
    └──────────────────────┬──────────────────────┘
                           │
    ┌──────────────────────▼──────────────────────┐
    │       CONVERT DATA REGARDING VOLTAGE OF       │
    │     BATTERY CELL INTO DIFFERENTIAL SIGNAL     │──S1040
    └──────────────────────┬──────────────────────┘
                           │
    ┌──────────────────────▼──────────────────────┐
    │ CALCULATE STATISTICAL VALUE FOR DIFFERENTIAL SIGNAL │──S1050
    └──────────────────────┬──────────────────────┘
                           │
    ┌──────────────────────▼──────────────────────┐
    │      DIAGNOSE THAT ABNORMALITY OF BATTERY CELL │
    │ OCCURS WHEN STATISTICAL VALUE FOR DIFFERENTIAL SIGNAL │──S1060
    │   IS EQUAL TO OR GREATER THAN PRESET REFERENCE VALUE │
    └──────────────────────┬──────────────────────┘
                           │
                    ┌──────▼───────┐
                    │     END      │
                    └──────────────┘
```

F I G . 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210186533
- KR 20210080069